# EUROPEAN PATENT APPLICATION

(11) **EP 3 950 850 A1**
(43) Date of publication of application: **09.02.2022**
(21) Application number: 20784549.6
(22) Date of filing: 23.03.2020
(51) Int. Cl.: C08L 101/12, C09K 5/14, C08K 3/00

(54) **HEAT-CONDUCTING COMPOSITION AND HEAT-CONDUCTING MEMBER**

(30) Priority: 29.03.2019 JP 2019067458
(71) Applicant: Sekisui Polymatech Co., Ltd., Saitama-city, Saitama 338-0837 (JP)
(72) Inventor: NAMIKI, Kazuhiro, Saitama-city, Saitama 338-0837 (JP)
(74) Representative: Ter Meer Steinmeister & Partner
(86) International application number: PCT/JP2020/012713
(87) International publication number: WO 2020/203412

(57) **Abstract**

A heat-conducting composition contains a binder and a heat-conducting filler, wherein the particle size distribution of the heat-conducting filler has a first maximum peak emerging first from the large-particle diameter side and a second maximum peak emerging on the smaller-particle diameter side than the first maximum peak; the first maximum peak is a peak caused by a spherical first heat-conducting filler, and the second maximum peak is a peak caused by a polyhedral second heat-conducting filler; the proportion (D2/D 1) of a particle diameter D2 indicating the second maximum peak to a particle diameter D1 indicating the first maximum peak is 1/30 to 1/10; and in the particle size distribution, with the geometric average of the particle diameter D1 and the particle diameter D2 being taken as a particle diameter DG, the frequency DGF in the range from 0.9 × DG to 1.1 × DG is 1/5 or lower of the lower frequency of a frequency D1F at the particle diameter D1 and a frequency D2F at the particle diameter D2.

## Description

### Technical Field

The present invention relates to a heat-conducting composition, and a heat-conducting member.

### Background Art

As heat-conducting members intervening between heat-generating elements and heat-dissipating elements and conducting heat generated by the heat-generating elements to the heat-dissipating elements, there are known heat-conducting sheets formed into sheet shapes, heat-conducting compositions having fluidity, and the like. Whereas the heat-conducting sheets are used by being interposed between the heat-generating elements and the heat-dissipating elements, the heat-conducting compositions can be used by being applied in clearances between the heat-generating elements and the heat-dissipating elements. Hence, in the case where the heat-generating elements and the heat-dissipating elements are in a fixed state and cannot be moved, the heat-conducting compositions can suitably be used.

As conventional means to raise the heat conductivity in such heat-conducting members, there have been adopted methods of using heat-conducting fillers having a high thermal conductivity, methods of raising the packing factor of heat-conducting fillers, methods of concurrently using, as heat-conducting fillers, those having large and small particle diameters, methods, in sheets, of orienting the major axes (or a high-heat conduction direction) of anisotropic fillers to the aiming heat conduction direction (for example, sheet thickness direction), and other methods.

For example, Patent Literature 1 discloses an encapsulant containing, at least, an inorganic filler whose particle shape is a polyhedral shape, an inorganic filler whose shape is a spherical shape, and a silicone resin. The Patent Literature also describes that by using the encapsulant in which plural kinds of inorganic fillers having different average particle diameters and different materials are mixed, the loss of heat at interfaces can be made low by reduction of the total interfacial area, and the thermal conductivity can be improved.

### Citation List

### Patent Literature

PTL1: JP 2018-50018 A

### Summary of Invention

### Technical Problem

The encapsulant of Patent Literature 1 is only a simple mixture of plural kinds of inorganic fillers having different average particle diameters and different materials, and this technique is not very much different from conventional techniques concurrently using large- and small-diameter particles to improve the heat conductivity, and it is unclear whether more improvement of the thermal conductivity has been attained than conventionally.

From the above, an object of the present invention is to provide a heat-conducting composition capable of exhibiting good heat conductivity.

### Solution to Problem

As a result of exhaustive studies, the present inventor has found that when large-particle diameter spherical particles and small-particle diameter polyhedral particles are used, the difference in particle diameter therebetween is in a predetermined range, and the content of particles having intermediate sizes between the spherical particles and the polyhedral particles is smaller, the thermal conductivity is more improved than conventionally, and this finding has led to the completion of the present invention. More specifically, the present invention is as follows.

[1] A heat-conducting composition, comprising a binder and a heat-conducting filler, wherein the particle size distribution of the heat-conducting filler has a first maximum peak emerging first from the large-particle diameter side and a second maximum peak emerging on the smaller-particle diameter side than the first maximum peak; the first maximum peak is a peak caused by a spherical first heat-conducting filler, and the second maximum peak is a peak caused by a polyhedral second heat-conducting filler; the proportion (D2/D1) of a particle diameter D2 indicating the second maximum peak to a particle diameter D1 indicating the first maximum peak is 1/30 to 1/10; and in the particle size distribution, with the geometric average of the particle diameter D1 and the particle diameter D2 being taken as a particle diameter DG, the frequency DGF in the range from 0.9 × DG to 1.1 × DG is 1/5 or lower of the lower frequency of a frequency D1F at the particle diameter D1 and a frequency D2F at the particle diameter D2.
[2] The heat-conducting composition according to [1], wherein the proportion (D2/D1) of the particle diameter D2 to the particle diameter D1 is 1/25 to 1/15.
[3] The heat-conducting composition according to [1] or [2], wherein the second heat-conducting filler has an aspect ratio (the length in the normal direction to the major axis/the length of the major axis), which is a ratio between the length in the normal direction to the major axis and the length of the major axis, of 0.7 or higher, and a sphericity, which is a proportion of the diameter of the maximum inscribed circle to the diameter of the minimum circumscribed circle, of 0.8 or lower.
[4] The heat-conducting composition according to any one of [1] to [3], wherein the ratio (D2F/D1F) between the frequency D1F and the frequency D2F is 0.3 to 3.0.
[5] The heat-conducting composition according to any one of [1] to [4], wherein the particle diameter D1 is 40 to 200 µm.
[6] The heat-conducting composition according to any one of [1] to [5], wherein the particle diameter D2 is 1 to 10 µm.
[7] The heat-conducting composition according to any one of [1] to [6], wherein the heat-conducting composition has a viscosity at 25°C at a rotating speed of 10 rpm of 50 to 1,000 Pa·s.
[8] A heat-conducting member, comprising a cured product made by curing a heat-conducting composition according to any one of [1] to [7].
[9] The heat-conducting member according to [8], wherein the heat-conducting member has an OO hardness of 90 or lower as measured by using a type-OO durometer and by a method according to ASTM D2240-05.
[10] The heat-conducting member according to [8] or [9], wherein the heat-conducting member is used by being formed into a sheet shape, and disposed and compressed between a heat-generating element and a heat-dissipating element.

### Advantageous Effect of Invention

According to the present invention, there can be provided a heat-conducting composition capable of exhibiting a good heat conductivity.

### Brief Description of Drawing

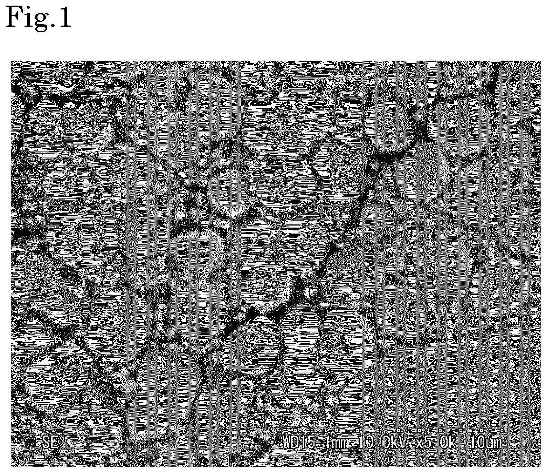

[Fig. 1] Fig. 1 is an SEM photograph of a cross section of a cured product of a heat-conducting composition of Example 1.

### Description of Embodiments

### [Heat-conducting composition]

Hereinafter, there will be described a heat-conducting composition according to an embodiment of the present invention.

The heat-conducting composition according to the present embodiment is a heat-conducting composition comprising a binder and a heat-conducting filler, wherein the particle size distribution of the heat-conducting filler has a first maximum peak emerging first from the large-particle diameter side and a second maximum peak emerging on the smaller-particle diameter side than the first maximum peak. Then, the first maximum peak is a peak caused by a spherical first heat-conducting filler, and the second maximum peak is a peak caused by a polyhedral second heat-conducting filler; and the proportion (D2/D1) of a particle diameter D2 indicating the second maximum peak to a particle diameter D1 indicating the first maximum peak is 1/30 to 1/10.

By using particles having predetermined shapes of a spherical first heat-conducting filler and a polyhedral second heat-conducting filler, and making D1 to be higher by a proportion equal to or higher than a predetermined proportion than D2, the curvature of the surface of the first heat-conducting filler having a spherical surface becomes relatively large and the second heat-conducting filler results in being enabled to be present as if being brought into surface contact with the first heat-conducting filler. It is presumed that consequently, effective heat conduction paths are formed and the thermal conductivity is raised.

Then in the particle size distribution, with the geometric average of the particle diameter D1 and the particle diameter D2 being taken as a particle diameter DG, the frequency DGF in the range (hereinafter, referred to as "medium-particle diameter range" in some cases) from 0.9 × DG to 1.1 × DG is 1/5 or lower of the lower frequency of a frequency D1F at the particle diameter D1 and a frequency D2F at the particle diameter D2. This means that there are present almost no particles in the medium-particle diameter range (hereinafter, referred to as "medium-particle diameter particles" in some cases). If such medium-particle diameter particles are present, the medium-particle diameter particles then inhibit the surface contact of the first heat-conducting filler with the second heat-conducting filler, making the improvement of the thermal conductivity unattainable. In the present invention, since the frequency DGF in the medium-particle diameter range is 1/5 or lower of the lower frequency of the frequency D1F at the particle diameter D1 and the frequency D2F at the particle diameter D2, it is presumed that almost no inhibition of the surface contact by the medium-particle diameter particles occurs, and a good heat conductivity is exhibited.

It is presumed that in the above way, the heat-conducting composition capable of exhibiting good heat conductivity can be obtained.

The frequency DGF in the medium-particle diameter range is 1/5 or lower of the lower frequency of the frequency D1F at the particle diameter D1 and the frequency D2F at the particle diameter D2, but is preferably 1/10 or lower and more preferably 1/50 or lower. When the frequency exceeds 1/5 of the lower frequency, the inhibition of the surface contact by the medium-particle diameter particles becomes liable to occur. Here, the maximum value in the frequencies in the medium-particle diameter range is taken as the frequency DGF.

Further in the particle size distribution, the ratio (D2F/D1F) between the frequency D1F and the frequency D2F is preferably 0.3 to 3.0. When the ratio is in this range, it becomes easy the proportion of the surface contact to be increased.

The particle diameter D1 is preferably in the range of 40 to 200 µm, more preferably in the range of 42 to 150 µm and especially preferably 44 to 100 µm. Due to the particle diameter D1 being in the range of 40 to 200 µm, the proportion of the surface contact can be increased.

The particle diameter D2 is preferably in the range of 1 to 10 µm, more preferably in the range of 1.5 to 8 µm and especially preferably in the range of 2 to 5 µm. Due to the particle diameter D2 being in the range of 1 to 10 µm, the proportion of the surface contact can be increased.

The proportion (D2/D1) of the particle diameter D2 to the particle diameter D1 is, as described above, 1/30 to 1/10, preferably 1/27 to 1/13 and more preferably 1/25 to 1/15. If the proportion is lower than 1/30 or higher than 1/10, a good thermal conductivity cannot be attained.

Hereinafter, there will be described the heat-conducting composition in more detail.

### (Heat-conducting filler)

The heat-conducting filler contains the first heat-conducting filler and the second heat-conducting filler.

The first heat-conducting filler is spherical, and the sphericity, which is a proportion of the diameter of the maximum inscribed circle to the diameter of the minimum circumscribed circle, is preferably 0.85 or higher and more preferably 0.9 or higher. Due to the sphericity being 0.85 or higher, the curved surface having a large curvature is increased and the proportion of the surface contact with the second heat-conducting filler can be increased.

Examples of the first heat-conducting filler include spherical particles formed of a metal, a metal oxide, a metal nitride, a metal carbide, a metal hydroxide, a carbon material, diamond or the like. Examples of the metal include aluminum, copper and nickel; examples of the metal oxide include aluminum oxide, magnesium oxide, zinc oxide and quartz; and examples of the metal nitride include boron nitride and aluminum nitride. The metal carbide includes silicon carbide; and the metal hydroxide includes aluminum hydroxide. Among these, there are included aluminum oxide, magnesium oxide, zinc oxide, quartz, boron nitride, diamond, aluminum nitride and the like; and among these, aluminum oxide is most preferable.

In the second heat-conducting filler, the aspect ratio (the maximum length in the normal direction to the major axis/the length of the major axis), which is a ratio of the maximum length in the normal direction to the major axis to the length of the major axis, is preferably 0.7 or higher and more preferably 0.8 or higher. The second heat-conducting filler is polyhedral, and the sphericity, which is a proportion of the diameter of the maximum inscribed circle to the diameter of the minimum circumscribed circle, is preferably 0.8 or lower and more preferably 0.78 or lower. Due to that the aspect ratio is 0.7 or higher and the sphericity is 0.8 or lower, the planar portions of the second heat-conducting filler are increased, enabling the proportion of the surface contact with the first heat-conducting filler to be increased. Here, the aspect ratio in the present invention, since being defined as "the maximum length in the normal direction to the major axis/the length of the major axis", takes a numerical value of 1.0 or lower.

Measuring methods of the aspect ratio and the sphericity are those described in Examples.

The second heat-conducting filler is also not limited in the material as long as being polyhedral, but the material includes aluminum oxide, diamond and titanium oxide in polyhedral shapes, and is, among these, preferably polyhedral aluminum oxide. As the polyhedral aluminum oxide, there can be used, for example, commercially available products, manufactured by, Nippon Light Metal Company, Ltd., Sumitomo Chemical Co., Ltd., Showa Denko K.K., and the like. Examples of the polyhedral shapes include octahedral shapes.

Here, for the particle diameter D1 indicating the first maximum peak, there may be used the spherical first heat-conducting filler having nearly the same median diameter as the particle diameter D1. Therefore, the median diameter of the first heat-conducting filler is preferably 40 to 200 µm, more preferably 42 to 150 µm and especially preferably 44 to 100 µm.

Similarly, for the particle diameter D2 indicating the second maximum peak, there may be used the polyhedral second heat-conducting filler having nearly the same median diameter as the particle diameter D2. Therefore, the median diameter of the second heat-conducting filler is preferably 1 to 10 µm, more preferably 1.5 to 8 µm and especially preferably 2 to 5 µm.

Here, the median diameter in the present description refers to a median diameter D50 in terms of the volume-average particle diameter in a particle size distribution measured by a laser diffraction scattering method (JIS R1629).

The mixing proportion (spherical first heat-conducting filler/polyhedral second heat-conducting filler) between the spherical first heat-conducting filler and the polyhedral second heat-conducting filler is, from the viewpoint of reduction of the viscosity of the heat-conducting composition, preferably 0.35 to 2.5 and more preferably 1.5 to 2.3.

It is preferable that the spherical first heat-conducting filler and the polyhedral second heat-conducting filler are both the same material, particularly aluminum oxide. Due to the both being aluminum oxide, the packing factor of the heat-conducting filler can easily be raised, enabling better heat conductivity to be exhibited.

The content rate (packing factor) of the heat-conducting filler in the heat-conducting composition is, in terms of the total of the first heat-conducting filler and the second heat-conducting filler, preferably 60 to 88% by volume and more preferably 70 to 86% by volume.

In the present invention, the particle size distribution of the heat-conducting filler may have a third maximum peak emerging next to the second maximum peak. The peaks may further be followed by a fourth, fifth and so on maximum peaks. In the case where the particle size distribution of the heat-conducting filler has the third maximum peak, the maximum peak is preferably a peak caused by a polyhedral third heat-conducting filler or a spherical third heat-conducting filler having a smaller median diameter than the second heat-conducting filler, and more preferably a peak caused by a polyhedral third heat-conducting filler. Due to having the third maximum peak, gap portions between the first heat-conducting filler and the second heat-conducting filler can be filled with the third heat-conducting filler, enabling the thermal conductivity to be improved.

From the viewpoint of more improving the thermal conductivity, the particle diameter D3 indicating the third maximum peak is preferably in the range of 0.1 to 1.0 µm and more preferably in the range of 0.2 to 0.8 µm.

From the viewpoint of the filling property of the gaps, the proportion (D3/D2) of the particle diameter D3 to the particle diameter D2 is preferably 1/20 to 1/2.

As the polyhedral third heat-conducting filler, there can be used the same as the second heat-conducting filler except for having a smaller median diameter than the second heat-conducting filler. Further as the spherical third heat-conducting filler, there can be used the same as the first heat-conducting filler except for having a smaller diameter than the first heat-conducting filler. In any cases, it is preferable that the material of the third heat-conducting filler is aluminum oxide.

The median diameter of the third heat-conducting filler is preferably 0.1 to 1.0 µm and more preferably 0.2 to 0.8 µm.

The mixing proportion (third heat-conducting filler/second heat-conducting filler) between the third heat-conducting filler and the second heat-conducting filler is, from the viewpoint of reduction of the viscosity of the heat-conducting composition, preferably 0.1 to 2.0 and more preferably 0.15 to 0.8.

### (Binder)

The binder includes thermosetting polymers and photocuring polymers, but is, in consideration of the productivity, preferably a thermosetting polymer. The thermosetting polymer is, from the viewpoint of the curing shrinkage, preferably an addition reaction-type polymer. When the heat-conducting composition is cured in the state of being interposed between a heat-generating element and a heat-dissipating element, in the case where the curing shrinkage is large, a gap is generated between the heat-generating element and the heat-dissipating element in some cases; but, in the case where the heat-conducting composition is the addition reaction-type polymer, since the curing shrinkage is small, the disadvantage of causing the gap hardly occurs.

The addition reaction-type polymer includes polyurethane, epoxy resins and poly-α-olefins, but a reaction curable silicone such as an organopolysiloxane is preferable in the point of the flexibility and the filling property of the heat-conducting filler.

The reaction-type silicone is preferably liquid at room temperature (25°C). The reaction-type silicone preferably contains a base resin and a curing agent being binder components, and the base resin is preferably a polyorganosiloxane having reactive groups capable of forming a crosslinking structure.

The reaction curable silicone is more preferably one containing an alkenyl group-containing organopolysiloxane (base resin) and a hydrogenorganopolysiloxane (curing agent).

The viscosity of the reaction curable silicone is preferably about 0.05 Pa·s to 2 Pa·s. The reaction curable silicone having a viscosity lower than 0.05 Pa·s is likely to have a low molecular weight and since the molecular weight is hardly increased even after it is cured, a cured product of the heat-conducting composition may be brittle. On the other hand, in the case of the silicone with a viscosity higher than 2 Pa·s, the viscosity of the heat-conducting composition is liable to increase, and therefore if the viscosity of the heat-conducting composition is brought into a desired range, the amount of the heat-conducting filler to be blended is smaller and the heat conductivity is difficult to increase.

From the viewpoint that a suitable flexibility is imparted to a cured product of the heat-conducting composition, the binder is preferably a thermosetting polymer and the OO hardness of the heat-conducting composition after curing as specified in ASTM D2240 is preferably 90 or lower and more preferably 5 to 90. In a flexible cured product having an OO hardness of 90 or lower (hereinafter, referred to as OO90 or lower in some cases), an excessive stress is hardly generated even in the case where the clearance between a heat-dissipating element and a heat-generating element changes by vibrations and shocks. On the other hand, the hardness of OO5 or higher results in a lower risk that a cured product of the heat-conducting composition is broken since the cured product has some degree of strength. The OO hardness is more preferably 50 to 85.

The value (hereinafter, referred to as "E hardness"), measured by a durometer of type E in Japanese Industrial Standards, JIS K6253, of the heat-conducting composition after curing is preferably 0 to 70 and more preferably 15 to 50. Due to the E hardness being 0 to 70, it becomes easy for the followability to shapes of heat-generating elements and heat-dissipating elements to be sufficiently acquired.

### (Silicone oil)

The heat-conducting composition of the present invention preferably contains a silicone oil. The silicone oil can be roughly classified into reactive silicone oil and non-reactive silicone oil.

The reactive silicone oil is a silicone oil having reactive functional groups and in a liquid state at room temperature (25°C). Inclusion of the reactive silicone oil can impart a suitable thixotropic property to the heat-conducting composition of the present invention.

The reactive functional group of the reactive silicone oil includes a hydroxy group, a carboxy group, an epoxy group and an amino group. Among these, from the viewpoint of the effect of imparting the thixotropic property, a hydroxy group is preferable.

As the reactive silicone oil, preferable is a reactive modified silicone oil having a main chain having siloxane bonds and reactive functional groups introduced to side chains bonded to the main chain or to terminals of the main chain. Examples of such a reactive modified silicone oil include carbinol-modified silicone oil, carboxy-modified silicone oil, epoxy-modified silicone oil and amino-modified silicone oil. Among these, preferable is at least one selected from the group consisting of carbinol-modified silicone oil, carboxy-modified silicone oil and epoxy-modified silicone oil; and more preferable is carbinol-modified silicone oil.

The reactive silicone oils can be used singly or in a combination of two or more.

The kinematic viscosity of the reactive silicone oil is, preferably, at 25°C, 10 mm²/s or higher and 10000 mm²/s or lower, more preferably 100 mm²/s or higher and 3000 mm²/s or lower and still more preferably 100 mm²/s or higher and 1000 mm²/s or lower.

The content of the reactive silicone oil is, with respect to 100 parts by mass of the reaction curable silicone, preferably in the range of 0.1 to 5 parts by mass, more preferably 0.2 to 4 parts by mass and still more preferably 0.5 to 3 parts by mass. When the content of the reactive silicone oil is 0.1 parts by mass or higher with respect to 100 parts by mass of the reaction curable silicone, the shape retention becomes good.

The non-reactive silicone oil is a silicone oil in a liquid state at room temperature (25°C) other than the reactive silicone oil. That is, the non-reactive silicone oil has no reactive functional group the reactive silicone oil has. Inclusion of the non-reactive silicone oil can impart the flexibility. Concurrent use of the reactive silicone oil and the non-reactive silicone oil provides a good shape retention of the heat-conducting composition after they are applied.

The non-reactive silicone oil includes straight silicone oil such as dimethyl silicone oil and phenyl methyl silicone oil, and besides, non-reactive modified silicone oil having non-reactive organic groups introduced to the main chain having siloxane bonds, side chains bonded to the main chain or terminals of the main chain. Examples of the non-reactive modified silicone oil include polyether-modified silicone oil, aralkyl-modified silicone oil, fluoroalkyl-modified silicone oil, long-chain alkyl-modified silicone oil, higher fatty acid ester-modified silicone oil, higher fatty acid amido-modified silicone oil and phenyl-modified silicone oil.

Among the above, as the non-reactive silicone oil, a straight silicone oil is preferable, and among the straight silicone oils, dimethyl silicone oil is more preferable.

The non-reactive silicone oils can be used singly or in a combination of two or more.

The kinematic viscosity of the non-reactive silicone oil is, from the viewpoint of imparting a good application property to the heat-conducting composition of the present invention, preferably, at 25°C, 10 mm²/s or higher and 10,000 mm²/s or lower and more preferably 50 mm²/s or higher and 1,000 mm²/s or lower.

The content of the non-reactive silicone oil is, with respect to 100 parts by mass of the reaction curable silicone, preferably in the range of 10 to 70 parts by mass, more preferably 15 to 70 parts by mass and still more preferably 20 to 60 parts by mass. When the content of the non-reactive silicone oil is 10 parts by mass or higher with respect to 100 parts by mass of the reaction curable silicone, the application property becomes good; and when 70 parts by mass or lower, the shape retention becomes good.

The content of the non-reactive silicone oil is preferably higher than the content of the reactive silicone oil. The content ratio [non-reactive silicone oil/reactive silicone oil] of the non-reactive silicone oil to the reactive silicone oil is, in mass ratio, preferably in the range of 5 to 100, more preferably 10 to 80, still more preferably 15 to 50 and further still more preferably 15 to 30.

The heat-conducting composition as described above preferably contains substantially no solvent. Containing substantially no solvent makes shape retention and thick film formation easier. It is preferable also environmentally. Here, "containing substantially no solvent" refers to such a state that the weight loss after the heat-conducting composition is heated at 100°C for 2 hours is 1% by mass or lower. That is, the solid content concentration of the heat-conducting composition is preferably 99% by mass or higher. The weight loss can be measured, for example, by using a thermogravimetric analyzer (TGA).

The heat-conducting composition of the present invention can be produced by adding the heat-conducting filler and other necessary additives (silicone oil and the like) to the binder before curing, and sufficiently stirring and dispersing the mixture. In the case where the binder is composed of a base resin and a curing agent, solid contents including the heat-conducting filler may be mixed in either one of the base resin and the curing agent, and thereafter, the other one thereof, which does not contain the solid contents, may be mixed; or, the solid contents including the heat-conducting filler may be mixed in both the base resin and the curing agent, and thereafter, the base resin and the curing agent may be mixed.

### <Forms of the heat-conducting composition>

The form of the heat-conducting composition of the present invention may be of a one-component type, or may be of a two-component type, which is used by mixing two components of a base resin and a curing agent and the like in the use time. The one-component type heat-conducting composition includes compositions containing a moisture-curable silicone as a reaction curable silicone.

As the two-component type heat-conducting composition, preferable are compositions containing the above-mentioned addition reaction curable silicone as a reaction curable silicone. Specifically, it is preferable that the two-component type heat-conducting composition is constituted of a first agent containing an addition reaction type organopolysiloxane as a base resin, such as an alkenyl group-containing organopolysiloxane, and a second agent containing a curing agent such as a hydrogenorganopolysiloxane.

In the case where the reaction curable silicone according to the present invention is of a two-component type, the heat-conducting filler and the like may be included in at least one of the first agent and the second agent. From the viewpoint of easily enhancing homogeneity of a mixture of the first agent and the second agent, the silicone oil is preferably contained in both of the first agent and the second agent in divided portions. From the similar viewpoint as in the above, the heat-conducting filler also is preferably contained in both of the first agent and the second agent in divided portions.

More specifically, it is more preferable that the two-component type heat-conducting composition is constituted of a first agent containing a base resin constituting a reaction curable silicone, a heat-conducting filler and preferably a silicone oil, and a second agent containing a curing agent constituting the reaction curable silicone, the heat-conducting filler, and preferably the silicone oil.

In the heat-conducting composition of the present invention, the viscosity at 25°C at a rotating speed of 1 rpm is preferably 5,000 Pa·s or lower, more preferably 4,500 Pa·s or lower and still more preferably 600 Pa·s or lower. When the viscosity is in this range, the heat-conducting composition becomes one having a predetermined fluidity and preferable workability. The lower limit of the viscosity is not especially limited, but is, for example, preferably 200 Pa·s or higher and more preferably 400 Pa·s or higher. Therefore, the viscosity range is preferably 400 to 5,000 Pa·s, more preferably 500 to 4,500 Pa·s and still more preferably 500 to 600 Pa·s.

Then, the viscosity at 25°C at a rotating speed of 10 rpm is preferably 1,000 Pa·s or lower, more preferably 600 Pa·s or lower and still more preferably 400 Pa·s or lower. The lower limit of the viscosity is not especially limited, but is, for example, preferably 50 Pa·s or higher and more preferably 100 Pa·s or higher. Therefore, the viscosity range at 25°C at a rotating speed of 10 rpm is preferably 50 to 1,000 Pa·s, more preferably 100 to 600 Pa·s and still more preferably 100 to 400 Pa·s.

Due to that the viscosity is as in the above, the heat-conducting composition is good in handleability, and the heat-conducting filler according to the present invention can be filled much.

### [Heat-conducting member]

The heat-conducting member of the present invention comprises a cured product made by curing the heat-conducting composition of the present invention.

The form of the heat-conducting member can be exemplified by a form constituted by filling the heat-conducting composition in an object containing, for example, a heat-dissipating element and a heat-generating element so as to fill up a clearance between the heat-generating element and the heat-dissipating element, and a form constituted by previously forming a heat-conducting member in a sheet shape or a predetermined shape, and interposing the heat-conducting member between a heat-generating element and a heat-dissipating element.

In the case where the heat-conducting member is of a sheet shape, the thickness of the cured product is preferably 0.03 to 1 mm and more preferably 0.3 to 1 mm. Due to being 0.03 to 1 mm, the cured product becomes suitable for applications to automobiles and the like and is preferable also in the productivity.

It is preferable that the OO hardness and the E hardness of the heat-conducting member of the present invention are in the same ranges as the OO hardness and the E hardness of the heat-conducting composition.

In particular, in the case where the heat-conducting member is of a sheet shape, due to that the OO hardness is 90 or lower and the E hardness is 70 or lower, when the heat-conducting member is compressed by a heat-generating element and a heat-dissipating element, the compression is attained in a low stress, which is preferable in that there can be made low the stress to the heat-generating element and the heat-dissipating element or a substrate on which they are installed. That is, it is preferable that the heat-conducting member is formed into a sheet shape, and disposed and compressed and used between a heat-generating element and a heat-dissipating element.

The heat-conducting member of the present invention is suitably used, for example, in vehicle applications, electronic device applications, architecture applications and the like. The heat-conducting member is useful also particularly as a cushioning material for vehicular parts used by being applied on peripheries of automobile parts.

Then, it is preferable that the heat-conducting member of the present invention forms a heat-dissipating structure by being installed on a heat-dissipating element. At this time, it is preferable that the heat-conducting member has a larger external shape than a heat-generating element, and it is preferable that when the heat-generating element is arranged on the heat-conducting member, the heat-generating element is arranged so that the entire of a predetermined surface of the heat-generating element is brought into contact with the heat-conducting member.

Alternatively, the heat-conducting member of the present invention can be previously formed integrally together with either one of a heat-generating element and a heat-dissipating element. For example, if the heat-conducting member is integrated to a predetermined position of a heat sink being a heat-dissipating element, a heat-dissipating structure can be formed only by installing the heat sink on a heat-generating element.

As the heat-dissipating element, preferable is one utilizing a material having a thermal conductivity of 20 W/mK or higher, for example, a material of a metal such as stainless steel, aluminum or copper, graphite, diamond, aluminum nitride, boron nitride, silicon nitride, silicon carbide or aluminum oxide. The heat-dissipating element using such a material includes heat sinks, housings and pipelines for heat dissipation.

The heat-generating element includes automobile parts such as EV batteries; usual power sources; electronic devices such as power transistors for power sources, power modules, thermistors, thermocouples and temperature sensors; and heat-generating electronic parts such as integrated circuit devices such as LSI and CPU.

### Examples

Hereinafter, the present invention will be described in more details by way of Examples, but the present invention is not any more limited to these Examples.

In the present Examples, a heat-conducting composition and a heat-conducting member obtained in each Example were evaluated by the following methods.

### [The particle size distribution, the aspect ratio and the sphericity of heat-conducting fillers]

A cured product of a heat-conducting composition was cut along the thickness direction by a Cross Section Polisher (CP). A cross section having emerged by the cutting work was photographed by a scanning electron microscope (SEM) at a magnification giving a visual field enabling 100 or more particles of a heat-conducting filler to be observed, and from an obtained SEM photograph, there were measured the lengths of the major axes of the heat-conducting filler and the maximum lengths in the normal direction to the major axes. Then, a particle size distribution (histogram) was determined by taking the arithmetic averages of the lengths of the major axes and the maximum lengths in the normal direction as particle diameters of individual particles; and there were determined a first maximum peak emerging first from the large-particle diameter side, a second maximum peak emerging on the smaller-particle diameter side than the first maximum peak, a particle diameter D1, a particle diameter D2 indicating the respective peaks, and the like.

In that case, the numerical intervals for data to produce the histogram can be set at, for example, 0.1 µm or larger and smaller than 0.15 µm, 0.15 µm or larger and smaller than 0.2 µm, 0.2 µm or larger and smaller than 0.3 µm, 0.3 µm or larger and smaller than 0.4 µm, 0.4 µm or larger and smaller than 0.6 µm, 0.6 µm or larger and smaller than 0.8 µm, 0.8 µm or larger and smaller than 1.2 µm, 1.2 µm or larger and smaller than 1.6 µm, 1.6 µm or larger and smaller than 2.4 µm, 2.4 µm or larger and smaller than 3.2 µm, 3.2 µm or larger and smaller than 4.8 µm, 4.8 µm or larger and smaller than 6.4 µm, 6.4 µm or larger and smaller than 9.6 µm, 9.6 µm or larger and smaller than 12 µm, 12 µm or larger and smaller than 16 µm, 16 µm or larger and smaller than 24 µm, 24 µm or larger and smaller than 32 µm, 32 µm or larger and smaller than 48 µm, 48 µm or larger and smaller than 64 µm, 64 µm or larger and smaller than 96 µm, 96 µm or larger and smaller than 128 µm, and 128 µm or larger and smaller than 192 µm.

Then, the frequency DGF in the medium-particle diameter range was defined as a frequency value of the corresponding interval in the histogram. In Fig. 1, there is shown an SEM photograph of a cross section emerging by cutting, in the thickness direction, a cured product of a heat-conducting composition obtained in Example 1.

Further, from the SEM photograph, there were measured the lengths of the major axes (of 100 particles) and the maximum lengths in the normal direction to the major axes; and there were calculated the aspect ratios (the maximum length in the normal direction to the major axis/the length of the major axis), and the arithmetic average thereof is shown in the column of aspect ratio of Table 2.

Further, from the SEM photograph, the diameter of the maximum inscribed circle was measured relative to the diameter of the minimum circumscribed circle; and the sphericity as a proportion of the two diameters was calculated.

Here, with regard to non-curable liquid heat-conducting compositions, since their cured products could not be cut along the thickness direction by a Cross Section Polisher (CP), powders left after liquid components were washed out were observed by an electron microscope and the various values were allowed to be similarly determined.

### [Viscosity]

The viscosity (Pa·s) at 25°C right after preparation of a heat-conducting composition (right after mixing of a first agent and a second agent described later) was measured by using a B-type viscometer (rotational viscometer, manufactured by Brookfield Engineering Laboratories, Inc., DV-E) under a set condition of a rotating speed of a spindle (SC4-14) of 1 rpm or 10 rpm. The value of the viscosity was read as a value after the spindle was rotated for 2 min at each rotating speed. Here, the value at a rotating speed of 10 rpm was taken as a first viscosity; and the viscosity at 1 rpm was taken as a second viscosity.

### [Thermal conductivity]

### (Thermal conductivity of heat-conducting compositions)

A heat-conducting composition of each Example was placed on a predetermined position of a test apparatus, and the thermal conductivity was measured by a method according to ASTM D5470-06. At this time, the application amount was regulated so that the thickness right after the application became 2.0 mm, 1.0 mm or 0.5 mm.

### (The thermal conductivity of cured products of heat-conducting compositions)

A heat-conducting composition of each Example was cured by leaving it at room temperature (25°C) for 24 hours, and then the cured product was used to fabricate a test piece for measuring the thermal conductivity having a rectangular shape of 25.4 × 25.4 mm and a thickness of 2.0 mm, 1.0 mm or 0.5 mm. Then, by using each test piece, the thermal conductivity was measured by a method according to ASTM D5470-06.

Further for Examples 1 to 3, the thermal conductivity improvement ratio was determined as follows.
- The thermal conductivity improvement ratio of Example 1: (the thermal conductivity (cured product) of Example 1/the thermal conductivity (cured product) of Comparative Example 1) - 1) × 100 (%)
- The thermal conductivity improvement ratio of Example 2: (the thermal conductivity (cured product) of Example 2/the thermal conductivity (cured product) of Comparative Example 2) - 1) × 100 (%)
- The thermal conductivity improvement ratio of Example 3: (the thermal conductivity (cured product) of Example 3/the thermal conductivity (cured product) of Comparative Example 6) - 1) × 100 (%)

### [The hardness of cured products]

The cured product of the heat-conducting composition of each Example was used to fabricate a test piece with 40 × 40 mm and 6 mm in thickness by using a mold for measuring the hardness.

Then, for each test piece, by using a type-OO durometer, the OO hardness was measured by a method according to ASTM D2240-05.

Further for each test piece, the E hardness was measured by using a type-E durometer.

### [Example 1]

A base resin constituting an addition reaction curable silicone and a dimethyl silicone oil being a non-reactive silicone oil were mixed to thereby prepare a first agent. On the other hand, a curing agent constituting the addition reaction curable silicone and a heat-conducting filler were mixed to thereby prepare a second agent. The amount (parts by mass) of each component to be blended in the total amount of the first agent and the second agent is as shown in Table 1.

The first agent and second agent obtained were mixed to thereby prepare a heat-conducting composition, and the various evaluations were carried out by the above methods. The results are shown in Table 1.

### [Examples 2, 3 and Comparative Examples 1 to 6]

Heat-conducting compositions were prepared by the same method as in Example 1, except for altering the formulations of the heat-conducting compositions to those shown in Table 1. The results are shown in Table 1.

**[Table 1]**

| | | | Example 1 | Example 2 | Example 3 | Comparative Example 1 | Comparative Example 2 | Comparative Example 3 | Comparative Example 4 | Comparative Example 5 | Comparative Example 6 |
|---|---|---|---|---|---|---|---|---|---|---|---|
| Formulation parts by mass | Binder | Addition reaction-type silicone | 100 | 100 | 100 | 100 | 100 | 100 | 100 | 100 | 100 |
| | Heat-conducting fillers | spherical 70 µm | 950 | | 470 | 950 | | 950 | 500 | 950 | 470 |
| | | spherical 45 µm | | 950 | | | 950 | 470 | | | |
| | | spherical 20 µm | | | | | | | 450 | | |
| | | spherical 3 µm | | | | 470 | 470 | 150 | | | 950 |
| | Heat-conducting fillers | polyhedral 20 µm | | | | | | | | 470 | |
| | | polyhedral 3 µm | 470 | 470 | 950 | | | | 470 | | |
| | | polyhedral 0.5 µm | 150 | 150 | 150 | 150 | 150 | | 150 | 150 | 150 |
| | Plasticizer | Silicone oil | 20 | 20 | 20 | 20 | 20 | 20 | 20 | 20 | 20 |
| | | Particle diameter D1 indicating first maximum peak (µm) | 75 | 45 | 75 | 75 | 45 | 75 | 75 | 75 | 75 |
| | | Particle diameter D2 indicating second maximum peak (µm) | 3.0 | 3.0 | 3.0 | 0.45 | 0.45 | - | 3.0 | 22 | 0.45 |
| | | D2/D1 | 0.040 | 0.067 | 0.040 | 0.006 | 0.010 | - | 0.040 | 0.293 | 0.006 |
| | | Geometric average particle diameter DG of D1 and D2 (µm) | 15 | 12 | 15 | 5.8 | 4.5 | - | 15 | 41 | 5.8 |
| Particle size distribution of Heat-conducting filler | | 0.9 × DG (µm) | 14 | 10 | 14 | 5.2 | 4.1 | - | 14 | 37 | 5.2 |
| | | 1.1 × DG (µm) | 17 | 13 | 17 | 6.4 | 5.0 | - | 17 | 45 | 6.4 |
| | | Appearance frequency at D1: D1F | 0.38 | 0.29 | 0.19 | 0.37 | 0.29 | 0.42 | 0.20 | 0.38 | 0.18 |
| | | Appearance frequency at D2: D2F | 0.20 | 0.21 | 0.39 | 0.07 | 0.07 | - | 0.21 | 0.23 | 0.07 |
| | | Maximum value of frequency DGF in the range from 0.9 × DG to 1.1 × DG | 0.001 | 0.004 | 0.001 | 0.066 | 0.052 | - | 0.064 | 0.050 | 0.15 |
| | | Ratio in height of "maximum value of frequency DGF" to "frequency at a smaller one of D1 and D2" | 0.005 | 0.02 | 0.01 | 0.93 | 0.74 | - | 0.32 | 0.22 | 2.17 |
| | | Viscosity (1 rpm) | 534 | 550 | 4350 | 2130 | 2150 | not flowing | 1053 | not flowing | - |
| | | Viscosity (10 rpm) | 225 | 239 | 445 | 446 | 671 | not flowing | 375 | not flowing | - |
| | | Hardness (OO) of cured product | 78 | 71 | 81 | 79 | 75 | - | 76 | - | 84 |
| Evaluations | | Hardness (E) of cured product | 22 | 50 | 23 | 20 | 25 | - | 23 | - | 25 |
| | | Thermal conductivity (composition) | 4.37 | 4.06 | 3.45 | 4.09 | 3.76 | - | 4.05 | 3.17 | 3.11 |
| | | Thermal conductivity (cured product) | 4.42 | 4.10 | 3.41 | 4.18 | 3.81 | - | 4.11 | 3.15 | 3.21 |
| | | Thermal conductivity improvement ratio | 6.7% | 8.0% | 6.2% | - | - | - | - | - | - |

Among components indicated in Table 1, the binder and the silicone oil were as follows. Here, any of the blend amounts shown in Table 1 was an active component amount.
- Base resin of the addition reaction curable silicone: viscosity of 400 mPa·s (25°C)
- Curing agent of the addition reaction curable silicone: viscosity of 300 mPa·s (25°C)
- Dimethyl silicone oil: viscosity of 100 mPa·s (25°C)

Then, the heat-conducting fillers were as indicated in the following Table 2, and commercially available products made of aluminum oxide were used for all of those fillers. The standard deviation, the aspect ratio and the sphericity in Table are values observed by an electron microscope and calculated. The numerical values described together with shapes are average particle diameters (median diameters).

**[Table 2]**

| | | Standard deviation | Aspect ratio | Sphericity |
|---|---|---|---|---|
| Heat-conducting fillers | spherical 70 µm | 21 | 0.98 | 0.91 |
| | spherical 45 µm | 16 | 0.96 | 0.88 |
| | spherical 20 µm | 7.4 | 0.97 | 0.91 |
| | spherical 3 µm | 1.5 | 0.95 | 0.86 |
| Heat-conducting fillers | polyhedral 20 µm | 3.2 | 0.85 | 0.74 |
| | polyhedral 3 µm | 0.47 | 0.86 | 0.77 |
| | polyhedral 0.5 µm | 0.08 | 0.82 | 0.71 |

Then, in Comparative Example 3, the mixture became dry and crumbling and the various measurements could not be carried out. Further in Comparative Example 5, the mixture became dry and crumbling and the measurements of the viscosity and the hardness could not be carried out, but the measurement of the thermal conductivity was possible. Further in Comparative Example 6, the mixture became clayey lumps and the viscosity measurement could not be carried out, but the measurements of the hardness and the thermal conductivity were possible.

From comparison of Example 1 with Comparative Example 1, and comparison of Example 2 with Comparative Example 2, it was found that with regard to the second heat-conducting filler, the thermal conductivity was more improved in the case of using polyhedral particles than in the case of using spherical particles. It was also found the viscosity was more lowered.

From comparison of Examples 1, 2 with Comparative Example 5, it was found that when the difference between D1 and D2 was at least 10 times or more (D2/D1 was 0.1 or lower), the thermal conductivity became good.

It was found that in the case where the polyhedron had a small particle diameter as in Comparative Example 2, that is, when the difference (D2/D1) in particle diameter between D1 and D2 was less than 30 times, the effect could not be anticipated.

From comparison of Example 1 with Comparative Example 4, it was found that even when the difference in particle diameter between D1 and D2 is suitable as in Comparative Example 4, containing the medium-particle diameter particles in a larger amount than the predetermined ratio in the medium-particle diameter range reduces the effect of improving the thermal conductivity.

### Industrial Applicability

The heat-conducting member using the heat-conducting composition of the present invention is suitably used, for example, as waterproof and vibration-proof materials in vehicle applications, electronic device applications and architecture applications.

## Claims

1. A heat-conducting composition, comprising a binder and a heat-conducting filler,
wherein a particle size distribution of the heat-conducting filler has a first maximum peak emerging first from the large-particle diameter side and a second maximum peak emerging on the smaller-particle diameter side than the first maximum peak;
the first maximum peak is a peak caused by a spherical first heat-conducting filler;
the second maximum peak is a peak caused by a polyhedral second heat-conducting filler;
a proportion (D2/D 1) of a particle diameter D2 indicating the second maximum peak to a particle diameter D1 indicating the first maximum peak is 1/30 to 1/10; and
in the particle size distribution, with a geometric average of the particle diameter D1 and the particle diameter D2 being taken as a particle diameter DG, a frequency DGF in the range from 0.9 × DG to 1.1 × DG is 1/5 or lower of the lower frequency of a frequency D1F at the particle diameter D1 and a frequency D2F at the particle diameter D2.

2. The heat-conducting composition according to claim 1, wherein the proportion (D2/D1) of the particle diameter D2 to the particle diameter D1 is 1/25 to 1/15.

3. The heat-conducting composition according to claim 1 or 2, wherein the second heat-conducting filler has an aspect ratio (a length in the normal direction to the major axis/a length of the major axis), which is a ratio between the length in the normal direction to the major axis and the length of the major axis, of 0.7 or higher, and a sphericity, which is a proportion of a diameter of the maximum inscribed circle to a diameter of the minimum circumscribed circle, of 0.8 or lower.

4. The heat-conducting composition according to any one of claims 1 to 3, wherein a ratio (D2F/D 1F) between the frequency D1F and the frequency D2F is 0.3 to 3.0.

5. The heat-conducting composition according to any one of claims 1 to 4, wherein the particle diameter D1 is 40 to 200 µm.

6. The heat-conducting composition according to any one of claims 1 to 5, wherein the particle diameter D2 is 1 to 10 µm.

7. The heat-conducting composition according to any one of claims 1 to 6, wherein the heat-conducting composition has a viscosity at 25°C at a rotating speed of 10 rpm of 50 to 1,000 Pa·s.

8. A heat-conducting member, comprising a cured product made by curing a heat-conducting composition according to any one of claim 1 to 7.

9. The heat-conducting member according to claim 8, wherein the heat-conducting member has an OO hardness of 90 or lower as measured by using a type-OO durometer and by a method according to ASTM D2240-05.

10. The heat-conducting member according to claim 8 or 9, wherein the heat-conducting member is used by being formed into a sheet shape, and disposed and compressed between a heat-generating element and a heat-dissipating element.
